# EUROPEAN PATENT APPLICATION

(11) **EP 4 852 629 A1**
(43) Date of publication of application: **09.12.2026**
(21) Application number: 26183161.4
(22) Date of filing: 04.06.2026
(51) Int. Cl.: H05K 5/00, H05K 7/14

(54) **FULL ACCESS HIGH DENSITY RACK**

(30) Priority: 05.06.2025 US 202563818427 P; 19.05.2026 US 202619681726
(71) Applicant: Vertiv Corporation, Westerville, OH 43082 (US)
(72) Inventor: KING, Ryan Jeremy, Westerville, 43082 (US)
(74) Representative: Ambroz, Simon

(57) **Abstract**

A full-access, high-density rack for IT equipment is disclosed. The high-density rack includes a server rack comprising one or more network servers along with a first side rack and a second side rack. The first side rack is mounted on a first side of the server rack and is configured to provide power connections to the one or more network servers. The second side rack is mounted on a second side of the server rack and is configured to provide communications cable connections to the one or more network servers. At least one cooling fan is mounted on a third side of the server rack, the cooling fan(s) being configured to draw air from the network servers. A first liquid cooling manifold is configured to provide cooling fluid to piping associated with the one or more servers.

## Description

### BACKGROUND

### 1. Field

This disclosure is related to information technology equipment, and more particularly, enclosures for housing information technology equipment.

### 2. Description of Related Art

Information technology (IT) equipment, such as servers, may be housed in racks when implemented in large organizations and facilities such as data centers. Each rack may include one or more servers, as well as power connections, cooling fluid connections, fans, and space for air cooling. As organizations increase in size, the density of IT equipment may increase commensurately. Similarly, the density of connections for power, cooling fluid, as well as space needed for fans and air cooling also increases.

### SUMMARY

A full-access, high-density rack for IT equipment is disclosed. One implementation of the high-density rack includes a server rack comprising one or more network servers along with a first side rack and a second side rack. The first side rack is mounted on a first side of the server rack and is configured to provide power connections to the one or more network servers. The second side rack is mounted on a second side of the server rack and is configured to provide communications cable connections to the one or more network servers. At least one cooling fan is mounted on a third side of the server rack, the cooling fan(s) being configured to draw air from the network servers. A first liquid cooling manifold is configured to provide cooling fluid to piping associated with the one or more servers.

### BRIEF DESCRIPTION OF THE DRAWINGS

The above and/or other aspects will become apparent and more readily appreciated from the following description of example embodiments, taken in conjunction with the accompanying drawings, in which:
FIG. 1 is a perspective view of one embodiment of a server rack.
FIG. 2 is a drawing including top, rear, and side views of a server rack.
FIG. 3 is a perspective view of a data center including multiple instances of a server rack according to the disclosure.
FIG. 4 includes side and top views of a server rack, illustrating various connections thereto.
FIG. 5 is a view of two different heat exchanges usable with a server rack according to the disclosure.
FIG. 6 is a schematic of a cooling system that includes a server rack of the present disclosure.
FIG. 7 is a perspective view of another embodiment of a server rack.

### DETAILED DESCRIPTION

Reference will now be made in detail to example embodiments which are illustrated in the accompanying drawings, wherein like reference numerals refer to like elements throughout. In this regard, the example embodiments may have different forms and may not be construed as being limited to the descriptions set forth herein.

It will be understood that the terms "include," "including," "comprise," and/or "comprising," when used in this specification, specify the presence of stated features, integers, steps, operations, elements, and/or components, but do not preclude the presence or addition of one or more other features, integers, steps, operations, elements, components, and/or groups thereof.

It will be further understood that, although the terms "first," "second," "third," etc., may be used herein to describe various elements, components, regions, layers and/or sections, these elements, components, regions, layers and/or sections may not be limited by these terms. These terms are only used to distinguish one element, component, region, layer or section from another element, component, region, layer or section.

As used herein, the term "and/or" includes any and all combinations of one or more of the associated listed items. Expressions such as "at least one of," when preceding a list of elements, modify the entire list of elements and do not modify the individual elements of the list.

Various terms are used to refer to particular system components. Different companies may refer to a component by different names - this document does not intend to distinguish between components that differ in name but not function.

Matters of these example embodiments that are obvious to those of ordinary skill in the technical field to which these example embodiments pertain may not be described herein in detail.

As the size and demand for computer processing power increases, the density of IT equipment in various organizations (e.g., data centers) increases correspondingly. The increasing density of IT equipment necessitates more power be brought into server racks, along with more communications cables and a higher concentration piping for cooling. Current rack designs do not accommodate the increased need for these services, nor allow for air flow to pass through. For example, the position of the power cables, networking cables, and cooling manifolds can create obstructions to airflow. This can cause the cooling fans to have to work harder to generate sufficient airflow to perform air cooling of the equipment in the rack.

The present disclosure is directed to a server rack having side cabinets (or side racks) for various connections, including communications cabling, power, and cooling connections (e.g., via cooling liquid manifolds). The server rack of the present disclosure further provides space for airflow, while also allowing a higher density of IT equipment to be implemented therein. The disclosure further contemplates various direct-to-chip cooling configurations.

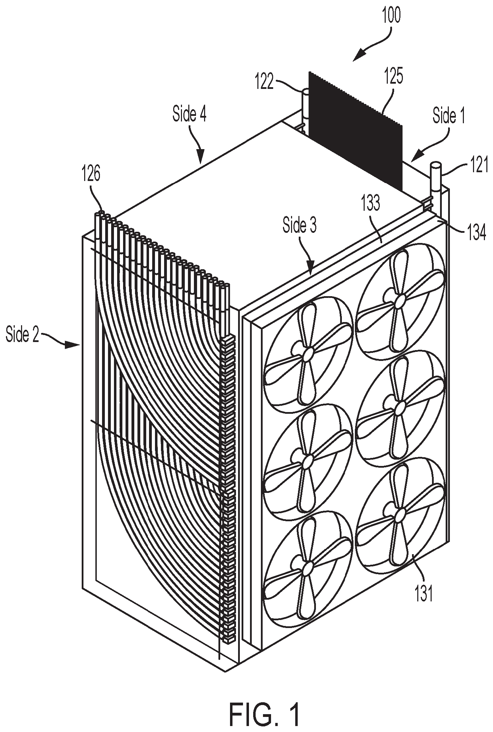

FIG. 1 is a perspective view of one embodiment of a server rack. In the illustrated example, server rack 100 includes a first side (labeled 'Side 1') having a cooling fluid inlet manifold 121, a cooling fluid outlet manifold 125, and a plurality of communications cable connections 125, all of which are implemented in a first side rack/cabinet. A second side rack/cabinet on a second side (labeled 'Side 2') of server rack 100 includes a plurality of power connections 126. In this embodiments, Side 1 is opposite Side 2 on server rack 100. A third side (labeled 'Side 3') of the server rack 100 includes a plurality of fans 131 and a heat exchanger 133, both of which may be implemented in a rear door 134. As shown here, Side 3 is orthogonal to Sides 1 and 2. Although not explicitly shown here, one or more servers may be mounted within server rack 100.

It is further noted that, in various embodiments, the arrangement of the various connections (or ports) may be different. For example, in an alternate embodiment, each of the first side rack (on Side 1) and the second side rack (on Side 2) may be arranged to accommodate both communications and power connections, which may provide additional flexibility for different server arrangements. Power and cable connections may be arranged in rows and/or columns. In embodiments in which at least some power and cable connections are implemented in the same side rack(s), the arrangements of rows and/or columns for power and cable connections may be interleaved with one another. The disclosure further contemplates that a given side rack (or racks) may allow for cables to pass through, with connections for power and/or communications cables being implemented on third or fourth sides (Sides 3 and 4, respectively) of the corresponding server rack.

Furthermore, while cooling inlet and outlet manifolds are shown on only one side in server rack 100, embodiments in which cooling fluid inlet manifold 121 and cooling fluid outlet manifold 125 are implemented on both the first and second sides (and more generally, any of the sides) are possible and contemplated. Moreover, while cooling fluid inlet manifold 121 and cooling fluid outlet manifold 125 are implemented in the first side rack (on Side 1) in this embodiment, other embodiments are contemplated in which these inlet and outlet manifolds are implemented in the second side rack (Side 2). Embodiments in which the cooling fluid inlet and outlet manifolds are implemented on different sides of a server rack, with respect to one another (e.g., a cooling inlet manifold in the first side rack and a cooling outlet manifold in the second side rack) are also possible and contemplated.

The communications cable connections 125 may be arranged to connect any suitable type of communications cable used in networks, such as CAT-5 or CAT-6 cabling. Through these cables, the one or more servers mounted in server rack 100 may communicate with other computers and devices (not shown) that are coupled to the network.

Power cables may be coupled to the power connections 126 to enable power to be provided to the server(s) mounted in server rack 100. Although not shown here, the power cables may be further coupled to a power source within the same facility in which server rack 100 is located.

Cooling fluid inlet manifold 121 and cooling fluid outlet manifold 122 are respectively arranged to convey cooling fluid into and out of the server rack 100. Although not explicitly shown in FIG. 1, piping is present to couple the manifolds to one another to circulate cooling fluid through server rack 100 and to the server(s) mounted therein. Flexible piping/hoses may also be included in some particular implementations. Cooling fluid inlet manifold 121 may convey cooling fluid into the rack where it draws heat from heat generating sources in the server(s), with this heat being drawn away and circulated away from its sources through the cooling fluid outlet manifold 122. In some implementations, a server mounted within server rack 100 may include a cooling plate attached thereto through which cooling fluid may be circulated to remove excess heat.

Various types of cooling fluids may be used. For example, a particular implementation may utilize propylene glycol or a mixture containing the same as cooling fluid. Some implementations may also use water or other types of refrigerants as cooling fluid.

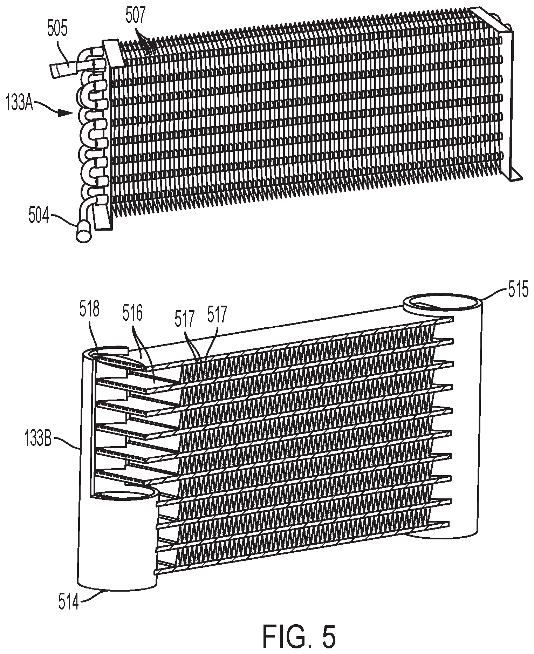

Fans 131 may operate when the server(s) mounted in server rack 100 are also operating. In particular, fans 131 are arranged to draw warm air from internal to the rack such that it is expelled into the surrounding environment, thereby drawing heat away from the servers. With regard to the heat exchanger 133, various openings (not shown here but shown in FIG. 5 and discussed below) to allow airflow. In some implementations, piping containing cooling fluid may also be in contact with or pass through heat exchanger 133 for further removal of heat.

Fans 131 and heat exchanger 134 are mounted to rear door 134 on a third side of sever rack 100. Rear door 134 may be opened to allow access to technicians for server maintenance, as well as the installation and/or removal of servers from server rack 100.

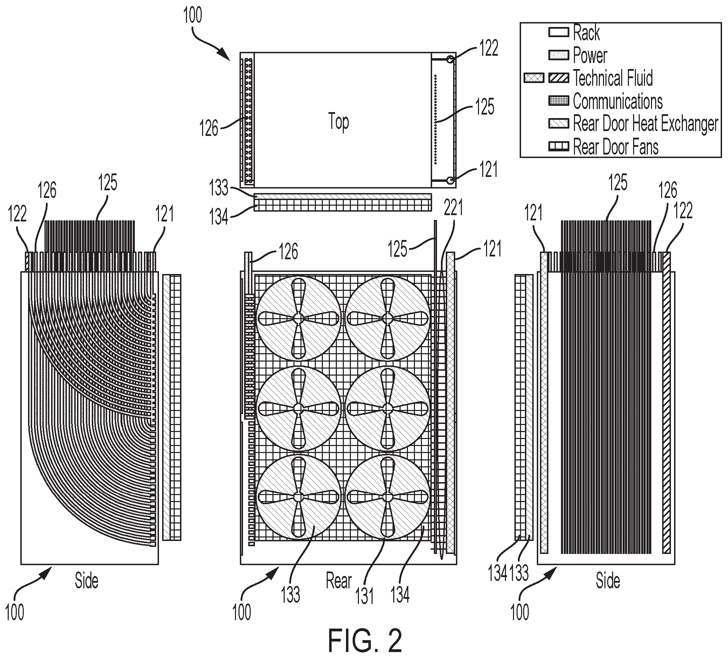

FIG. 2 is a drawing including top, rear, and side views of a server rack according to the disclosure. Server rack 100 as shown in FIG. 2 includes similar elements as the embodiment discussed above with reference to FIG. 1. These elements includes cooling fluid inlet manifold 121, cooling fluid outlet manifold 122, communications cable connections 125, power connections 126, and a rear door 134 that includes fans 131 and heat exchanger 133. FIG. 2 also illustrates additional details of the cooling fluid inlet manifold 121, in particular the piping connections 221. Similar piping connection are present on cooling fluid outlet manifold 122.

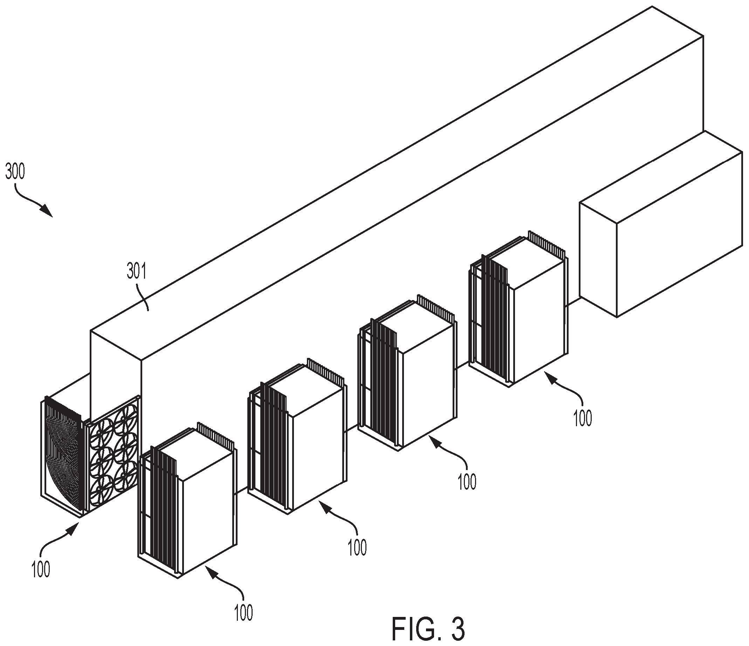

FIG. 3 is a perspective view of a data center including multiple instances of a server rack according to the disclosure. In this particular example, data center 300 includes a plurality of server racks 100 in accordance with the disclosure, with the racks being arranged in rows. Furthermore, the server racks 100 are arranged such that their respective fans blow are into a hot aisle containment area 301. Although not shown here, the facility may include additional fans that remove warm air from the hot aisle containment area.

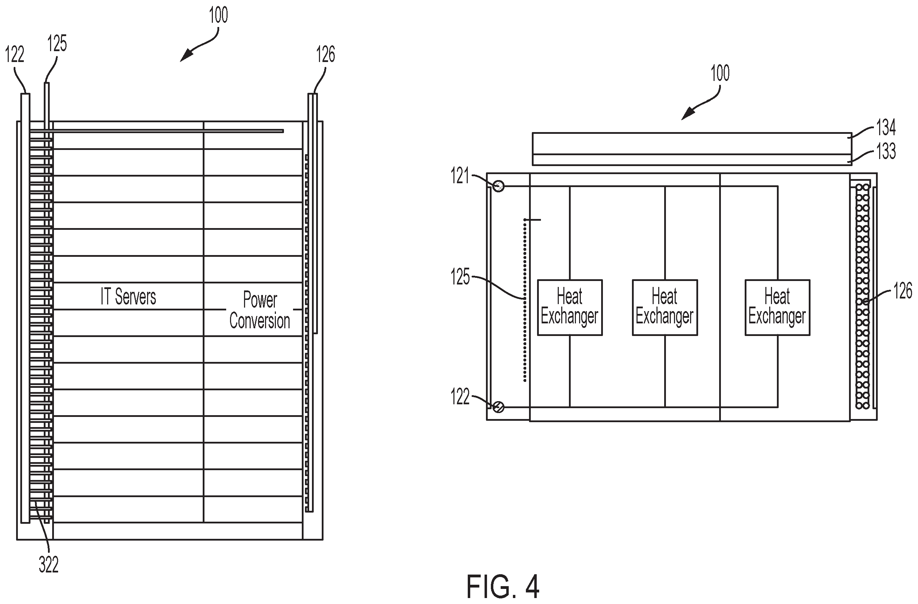

FIG. 4 includes side and top views of a server rack, illustrating various connections thereto. In this drawing, the cooling fluid outlet manifold 122 and its corresponding piping connections 322 are shown. Piping implemented within server rack 100 may couple the various piping connections to pipes/hose that are further connected to corresponding piping connection of the cooling fluid inlet manifold 121. Accordingly, the cooling fluid may flow into the rack via the cooling fluid inlet manifold 121, through the various pipes/hoses, and away from the rack via cooling fluid outlet manifold 122. FIG. 4 also illustrates communications cable connections 125 and power connections 126.

In the side view (left) in FIG. 4, respective portions of server rack 100 dedicated to the servers and power are shown. The power conversion portion may convert input power to the power specified for the servers (e.g., converting a 480 VAC input power to 50 VDC power for the servers). In alternate implementations, power conversion may be implemented in one of the side racks.

The top view of FIG. 4 illustrates fluid distribution through the server rack. In the illustrated example, multiple heat exchangers are implemented within server rack 100, including within the server portion as well as in the power conversion portion. Cooling fluid may be input through cooling inlet manifold 121, pass through the heat exchangers, absorbing heat therefrom, which is then output through cooling output manifold 122. The cooling fluid may be circulated to and from a refrigeration unit (not shown) to keep both the servers and power conversion circuitry within specified temperature limits.

FIG. 5 is a view of two different heat exchanges usable with a server rack according to the disclosure. These heat exchangers may be used in various implementations of server rack 100 as discussed above.

Heat exchanger 133A as shown here is a tube-and-fin type heat exchanger. Cooling fluid may be provided into piping routed through heat exchanger 133 at inlet 504, with the fluid exiting through outlet 505. In various implementations, flexible hosing may be used to couple inlet 504 and outlet 505 to corresponding connections on cooling fluid inlet and outlet manifolds, respectively. Cooling fluid running through the piping of heat exchanger 133A may extract heat from the surrounding air, including air drawn through the various fins 507. The fins are arranged such that air may flow through the heat exchanger 133, particularly when drawn through by fans adjacent thereto. The fins may extract heat from the air flowing through, and some of this heat may be transferred piping in contact with the fins.

Heat exchanger 133B in the embodiment shown is a microchannel type heat exchanger, and includes a cooling fluid inlet pipe 514 and a cooling fluid outlet pipe 515, both of which may be coupled to respective manifolds using flexible hosing. A plurality of horizontal fins 516 each include a corresponding plurality of microchannels 518 through which cooling fluid may flow and extract heat. Heat exchanger 133B additionally includes pluralities of fins 517 implemented between each of the horizontal fins 516. Fins 517 are placed in a triangular arrangement in this non-limiting example, and allow airflow through heat exchanger 133B. Accordingly, heat may be extracted from air flowing through heat exchanger 133B by fins 516 and 517, with at least some of this heat carried away by cooling fluid passing through the various microchannels 518.

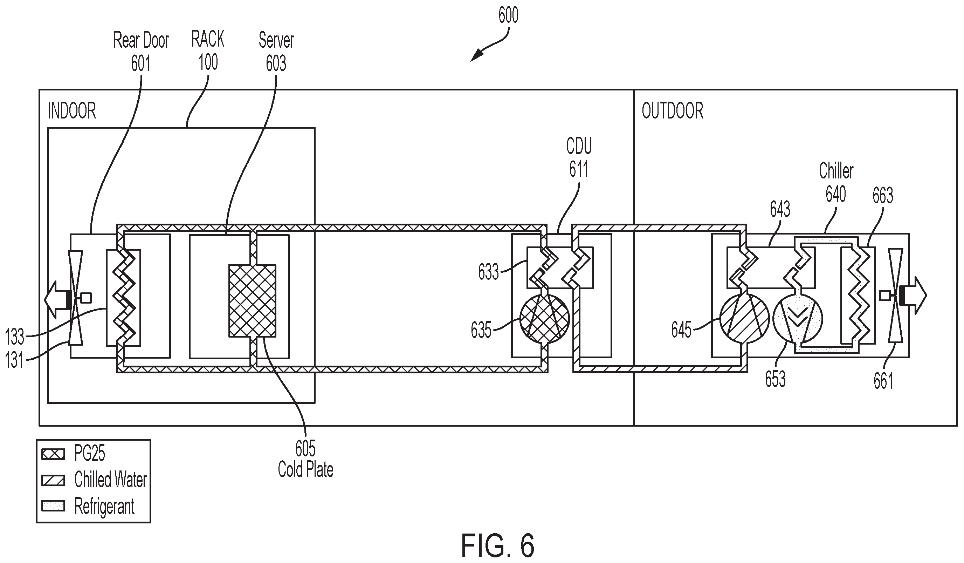

FIG. 6 is a schematic of a cooling system that includes a server rack of the present disclosure. In the example shown cooling system 600 is configured to provide cooling to one or more servers 603 mounted within server rack 100. The cooling system 600 includes both an indoor component and an outdoor component. The outdoor component includes chiller 640. The indoor component includes coolant distribution unit 611 and server rack 100.

The outdoor component of cooling system 600 includes a chiller 640, which is configured to extract and expel heat drawn from the indoor component. Chiller 640 includes one or more fans 661, heat exchangers 663 and 643, a refrigerant pump 653, and a chilled water pump 645. Refrigerant pump 653 circulates refrigerant through heat exchangers 643 and 663. Heat may be extracted from refrigerant flowing through heat exchanger 643 and transferred to heat exchanger 663, where it is subsequently extracted and expelled via air flow induced by fan 661. Heat exchangers 643 and 663 may be either of the types discussed above with reference to FIG. 5, or any other suitable type.

Chilled water pump 645 pumps chilled water through the illustrated path between heat exchanger 643 (located in the outdoor component of cooling system 600) and heat exchanger 663 (located in the indoor component of cooling system 663). Using the circulated chilled water, heat may be extracted from heat exchanger 633 and transferred to heat exchanger 643, where it may be subsequently extracted by circulating refrigerant pumped by refrigerant pump 653.

Coolant pump 635 is configured to circulate cooling fluid through the indoor component that includes server rack 100. The cooling fluid may be circulated through at least one heat exchanger 133 that is located on a rear door 601 of a corresponding server rack 100. In various implementations, the system may be arranged to circulate cooling fluid through additional heat exchangers in additional server racks 100.

Server rack 100 also includes at least one server 603 having a cold plate 605 attached thereto. The cold plate 605 extracts waste heat from the server 603. Furthermore, the system is arranged such that cooling fluid is circulated across or through cold plate 605 to carry the extracted heat away, downstream to heat exchanger 633. This may provide direct cooling to server 603 in order to maintain its operation within a specified temperature range. Additional servers mounted within server rack 100 may be similarly configured to a cold plate 605 and corresponding cooling fluid connections.

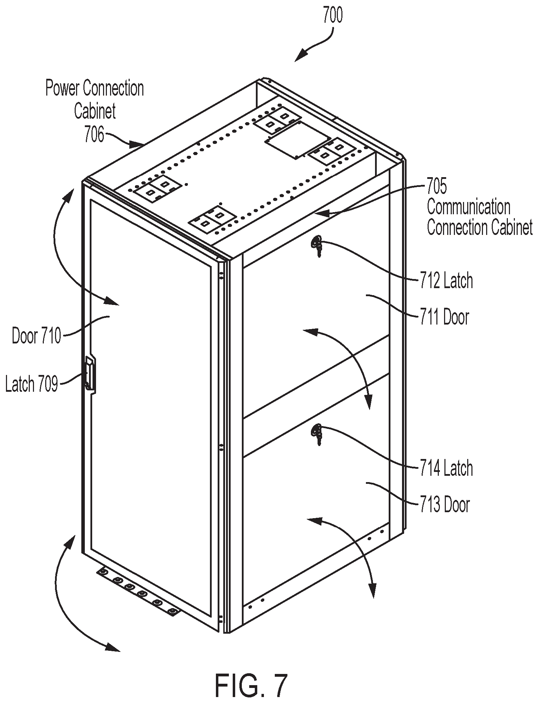

FIG. 7 is a perspective view of another embodiment of a server rack. In the embodiment shown, server rack 100 includes a communication connection cabinet 705 on one side of the rack and a power connection cabinet 706 on another, opposite side of the rack. A third side includes a door 710 having a latch 709 to allow the door to be opened or otherwise secured in place. Although not explicitly shown here, door 710 may have cooling fans integrated therein, similar to the embodiment shown in, e.g., FIGS. 1 and 2.

Communications cabinet 705 in the embodiment shown also includes doors 711 and 713, including latches 712 and 714. Doors 711 and 713 as shown here are implemented as part of communications cabinet 705. Although not explicitly shown here, similar doors may be implemented on power connection cabinet 706. These doors, when open, may allow access to the various connections within their respective cabinets. Accordingly, technicians may plug and/or unplug communications/power cables via the access these doors provide when open. When closed, these doors may provide a measure of protection from the external environment. Latches 712 and 714 may secure these doors in place when closed.

It may be understood that the example embodiments described herein may be considered in a descriptive sense only and not for purposes of limitation. Descriptions of features or aspects within each example embodiment may be considered as available for other similar features or aspects in other example embodiments.

Described herein are also the following clauses:
1. An apparatus for providing services to one or more servers, the apparatus comprising:
   a server rack comprising one or more servers;
   a first side rack mounted on a first side of the server rack, wherein the first side rack is configured to house one or more power connections to the one or more servers;
   a second side rack mounted on a second side of the server rack, wherein the second side rack is configured to house one or more communications cable connections to the one or more servers;
   one or more cooling fans mounted on a third side of the server rack, wherein one or more cooling fans are configured to draw air from the servers; and
   a first liquid cooling manifold configured to provide a cooling fluid to a piping associated with the one or more servers.
2. The apparatus of clause 1, wherein the first liquid cooling manifold is located on the second side rack.
3. The apparatus of clause 2, wherein the second rack further includes a second liquid cooling manifold coupled to receive the cooling fluid from the piping associated with the one or more servers.
4. The apparatus of clause 1, further comprising a heat exchanger on the third side of the server rack and adjacent to the one or more cooling fans.
5. The apparatus of clause 1, wherein the third side further comprises a door openable to access the one or more servers.
6. The apparatus of clause 1 wherein the first side of the server rack is opposite the second side of the server rack.
7. The apparatus of clause 1, wherein the cooling fluid comprises a mixture including propylene glycol.
8. The apparatus of clause 1, wherein the cooling fluid comprises water.
9. The apparatus of clause 1, further comprising a cold plate coupled to one of the one or more servers, wherein the cold plate is coupled to receive cooling fluid.
10. A method comprising:
   providing power, via a plurality of power connections, to one or more servers mounted in a server rack, wherein the plurality of power connections are implemented in a first side cabinet mounted on a first side of the server rack;
   communicating, via a plurality of communications cable connections in a second side cabinet mounted on a second side of the server rack, with the one or more servers;
   providing air flow through the server rack using one or more cooling fans mounted on a third side of the server rack; and
   providing cooling fluid, via a first liquid cooling manifold, to a piping associated with the one or more servers.
11. The method of clause 10, further comprising receiving the cooling fluid at a second liquid cooling manifold, wherein the first and second liquid cooling manifolds are located in the second side cabinet.
12. The method of clause 10, further comprising extracting heat from air drawn through the server rack, wherein the extracting comprises operating a heat exchanger located on the third side of the server rack.
13. The method of clause 10, further comprising extracting waste heat from the one or more servers, wherein the extracting of waste heat comprises circulating cooling fluid through a cold plate coupled to the one or more servers.
14. The method of clause 10, wherein providing air flow through the server rack using the one or more cooling fans mounted on the third side comprises drawing warm air from internal to the rack and expelling it into a surrounding environment.
15. The method of clause 10, wherein the cooling fluid comprises water.
16. The method of clause 10, wherein the cooling fluid comprises propylene glycol.
17. A system comprising:
   a server rack configured to mount one or more servers;
   a first side rack mounted on a first side of the server rack, the first side rack configured to provide a plurality of power connections to the one or more servers;
   a second side rack mounted on a second side of the server rack, the second side rack configured to provide a plurality of communications cable connections to the one or more servers;
   a cooling assembly mounted on a third side of the server rack, the cooling assembly comprising:
      one or more cooling fans configured to draw air from the one or more servers; and
      a heat exchanger adjacent to the one or more cooling fans; and
      a liquid cooling subsystem comprising a first cooling manifold configured to circulate cooling fluid through piping associated with the one or more servers.
18. The system of clause 17, wherein the liquid cooling subsystem further comprises a second cooling manifold configured to receive cooling fluid from the piping associated with the one or more servers.
19. The system of clause 17, further comprising a cold plate thermally coupled to at least one of the one or more servers, wherein the cold plate is configured to receive cooling fluid from the liquid cooling subsystem.
20. The system of clause 17, wherein the first side rack and the second side rack are arranged opposite one another on the server rack, and wherein the heat exchanger is mounted to a rear door on the third side of the server rack, the rear door being openable to provide access to the one or more servers.

## Claims

1. An apparatus for providing services to one or more servers, the apparatus comprising:
a server rack comprising one or more servers;
a first side rack mounted on a first side of the server rack, wherein the first side rack is configured to house one or more power connections to the one or more servers;
a second side rack mounted on a second side of the server rack, wherein the second side rack is configured to house one or more communications cable connections to the one or more servers;
one or more cooling fans mounted on a third side of the server rack, wherein one or more cooling fans are configured to draw air from the servers; and
a first liquid cooling manifold configured to provide a cooling fluid to a piping associated with the one or more servers.

2. The apparatus of claim 1, wherein the first liquid cooling manifold is located on the second side rack.

3. The apparatus of claim 2, wherein the second rack further includes a second liquid cooling manifold coupled to receive the cooling fluid from the piping associated with the one or more servers.

4. The apparatus of any one of the preceding claims, further comprising a heat exchanger on the third side of the server rack and adjacent to the one or more cooling fans.

5. The apparatus of any one of the preceding claims, wherein the third side further comprises a door openable to access the one or more servers.

6. The apparatus of any one of the preceding claims, wherein the first side of the server rack is opposite the second side of the server rack.

7. The apparatus of any one of the preceding claims, wherein the cooling fluid comprises a mixture including propylene glycol.

8. The apparatus of any one of the claims 1 to 6, wherein the cooling fluid comprises water.

9. The apparatus of any one of the preceding claims, further comprising a cold plate coupled to one of the one or more servers, wherein the cold plate is coupled to receive cooling fluid.

10. The apparatus of claim 1, wherein the first side rack and the second side rack are arranged opposite one another on the server rack, and wherein a heat exchanger is mounted to a rear door on a third side of the server rack, the rear door being openable to provide access to the one or more servers.

11. A method comprising:
providing power, via a plurality of power connections, to one or more servers mounted in a server rack, wherein the plurality of power connections are implemented in a first side cabinet mounted on a first side of the server rack;
communicating, via a plurality of communications cable connections in a second side cabinet mounted on a second side of the server rack, with the one or more servers;
providing air flow through the server rack using one or more cooling fans mounted on a third side of the server rack; and
providing cooling fluid, via a first liquid cooling manifold, to a piping associated with the one or more servers.

12. The method of claim 11, further comprising receiving the cooling fluid at a second liquid cooling manifold, wherein the first and second liquid cooling manifolds are located in the second side cabinet.

13. The method of any one of the claims 11 to 12, further comprising extracting heat from air drawn through the server rack, wherein the extracting comprises operating a heat exchanger located on the third side of the server rack.

14. The method of any one of the claims 11 to 13, further comprising extracting waste heat from the one or more servers, wherein the extracting of waste heat comprises circulating cooling fluid through a cold plate coupled to the one or more servers.

15. The method of any one of the claims 11 to 14, wherein providing air flow through the server rack using the one or more cooling fans mounted on the third side comprises drawing warm air from internal to the rack and expelling it into a surrounding environment; optionally, wherein the cooling fluid comprises water or wherein the cooling fluid comprises propylene glycol.
